(19) Europäisches Patentamt / European Patent Office / Office européen des brevets

(11) **EP 2 662 667 B1**

(12) **FASCICULE DE BREVET EUROPEEN**

(45) Date de publication et mention
de la délivrance du brevet:
**06.01.2016   Bulletin 2016/01**

(51) Int Cl.:
**G01D 5/241** *(2006.01)*       **G01R 27/26** *(2006.01)*

(21) Numéro de dépôt: **12167469.1**

(22) Date de dépôt: **10.05.2012**

(54) **Procédé de mesure d'un paramètre physique et circuit électronique d'interface d'un capteur capacitif pour sa mise en oeuvre**

Verfahren zur Messung einer physikalischen Größe und elektronischer Schnittstellenschaltkreis für einen kapazitiven Sensor zu dessen Durchführung

Method of measuring a physical parameter and electronic circuit to interface with a capacitive sensor for implementing same

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**13.11.2013   Bulletin 2013/46**

(73) Titulaire: **EM Microelectronic-Marin SA
2074 Marin (CH)**

(72) Inventeurs:
• **Grosjean, Sylvain
25500 Les Fins (FR)**
• **Entringer, Christophe
1426 Corcelles-près-Concise (CH)**

(74) Mandataire: **Giraud, Eric et al
ICB
Ingénieurs Conseils en Brevets SA
Faubourg de l'Hôpital 3
2001 Neuchâtel (CH)**

(56) Documents cités:
**EP-A1- 0 525 830       WO-A1-2004/113930
FR-A1- 2 176 724**

EP 2 662 667 B1

**Description**

L'invention concerne un procédé de mesure d'un paramètre physique, tel qu'une accélération, une vitesse angulaire, une force ou une pression, au moyen d'un circuit électronique d'interface relié à un capteur capacitif.

L'invention concerne également un circuit électronique d'interface d'un capteur capacitif pour la mise en oeuvre du procédé de mesure. Le capteur capacitif est composé d'au moins deux condensateurs montés en différentiel. Une électrode commune des condensateurs est susceptible de se déplacer entre deux électrodes fixes sous l'action par exemple d'une force pour modifier la valeur capacitive de chaque condensateur.

Dans une conception traditionnelle simple d'un tel capteur capacitif, l'électrode commune, qui est mobile, fait partie d'une armature maintenue élastiquement entre les deux électrodes fixes. Dans ce cas, le capteur capacitif peut être capable d'opérer une mesure selon une direction de mouvement de l'électrode mobile. Au repos, cette électrode commune mobile se trouve normalement à égale distance de l'une et de l'autre électrode fixe pour avoir des capacités de valeur égale des deux condensateurs. L'électrode commune mobile peut se déplacer d'une certaine distance en direction de l'une ou l'autre des électrodes fixes sous l'action notamment d'une force. Ainsi la valeur capacitive de chaque condensateur varie inversement. Le circuit électronique d'interface relié au capteur capacitif permet ainsi de fournir un signal de sortie analogique. Ce signal de sortie analogique est défini sous la forme d'une tension dépendant de la variation des capacités des deux condensateurs.

Un tel circuit électronique d'interface d'un capteur capacitif est décrit dans l'article rédigé par MM. H. Leuthold et F. Rudolph, qui est paru dans la revue intitulée "Sensors and actuators" A21-A23 (1990), pages 278 à 281.

Le capteur capacitif peut être un accéléromètre pour effectuer une mesure d'accélération en liaison avec un circuit électronique d'interface. Il peut s'agir d'un accéléromètre uniaxe comme le capteur capacitif susmentionné ou d'un accéléromètre multiaxe ou triaxial pour effectuer une mesure dans les trois directions X, Y et Z. Un tel accéléromètre triaxial du type MEMS peut comprendre une masse unique, c'est-à-dire une masse inertielle commune aux trois paires de condensateurs différentiels, ou trois masses pour les trois paires de condensateurs. Dans le premier cas, une seule électrode commune et six électrodes fixes sont prévues, alors que pour le second cas, une électrode commune avec deux électrodes fixes sont prévues pour chaque paire de condensateurs.

Aussi bien le circuit électronique, que le capteur capacitif, tel qu'un accéléromètre MEMS, sont réalisés chacun dans un substrat semi-conducteur. De ce fait, des capacités parasites à l'entrée du circuit électronique s'ajoutent aux capacités des condensateurs du capteur capacitif MEMS. Ces capacités parasites ne dépendent pas du déplacement de l'électrode mobile, ce qui a pour conséquence de créer des non-linéarités et également de faire baisser la sensibilité ou le gain du circuit électronique. Il en est de même avec le capteur capacitif MEMS, où le potentiel du substrat lors du fonctionnement du capteur crée également des non-linéarités. La moyenne des forces électrostatiques n'est ainsi pas nulle dans un mode de repos du capteur et du circuit électronique. De par l'influence du potentiel du substrat sur la force électrostatique, cela conduit à une variation de la force réelle mesurée, qui est appliquée sur l'électrode commune mobile, ce qui est un inconvénient.

Pour effectuer une mesure d'une force, d'une accélération ou d'une pression par l'intermédiaire du circuit électronique, les électrodes fixes de deux condensateurs ou des paires de condensateurs sont polarisées ou excitées cycliquement par des tensions de polarité opposée par rapport à une tension de référence au repos. En polarisant les deux électrodes fixes à des niveaux de tension différents, la différence de charges sur l'électrode mobile peut être mesurée et convertie en au moins une tension en sortie du circuit électronique. Lorsque la ou les tensions de sortie sont stabilisées à leur valeur finale, la charge totale sur l'électrode mobile devient nulle. Par la suite, ces tensions de sortie sont fournies échantillonnées à un circuit de traitement.

Comme la mesure d'une force, d'une accélération ou d'une pression, est dépendante des non-linéarités susmentionnées et de tout écart de tension lié aux composants électroniques non appariés, le brevet EP 1 835 263 B1 propose une solution à ce problème. Une double structure symétrique dans le circuit électronique est proposée notamment avec deux intégrateurs à la suite de l'amplificateur à transfert de charges. Chaque intégrateur fournit en sortie une tension de sortie analogique correspondante selon une polarisation positive des électrodes ou une polarisation négative des électrodes. Grâce à cela, un écart de tension (offset) dû à la technologie ou à la variation de tension d'alimentation peut être minimisé voire supprimé à l'aide des deux tensions de sortie analogiques des intégrateurs. De plus, le potentiel du substrat n'a plus d'importance comme le circuit électronique comprend une double structure identique à fonctionnement totalement symétrique.

Cependant un inconvénient d'un tel circuit électronique du document de brevet EP 1 835 263 B1, est qu'il fournit des signaux de sortie, tels que des tensions de sortie, sous forme analogique. Ceci nécessite l'emploi de deux intégrateurs. Cela ne permet pas de réduire de manière suffisante la taille des composants intégrés et la consommation électrique du circuit électronique intégré. De plus, ce circuit électronique n'est prévu que pour effectuer une mesure avec un capteur capacitif selon un seul axe de mesure.

Il est donc préféré de réaliser un circuit électronique, qui fournit en sortie des signaux numériques de mesure. A ce titre, on peut citer la demande de brevet WO 2004/113930 A1, qui décrit un tel circuit électronique relié à un capteur capacitif uniaxe ou multiaxe pour la mesure d'une accélération. Il est prévu à la suite de l'amplificateur à transfert de charges, qui est relié à l'électrode commune mobile, une logique spécifique à chaque axe de mesure, qui traite des signaux numériques de mesure. Chaque logique fournit en sortie un signal binaire de mesure représentatif d'un niveau de tension de mesure fonction du déplacement de l'électrode mobile par rapport aux électrodes fixes pour chaque axe successivement. Le signal binaire de mesure est fourni successivement pour chaque axe à un convertisseur numérique-analogique. Ce convertisseur fournit dans une phase de chaque cycle de mesure pour un axe sélectionné, une tension de mesure aux électrodes en alternance avec une phase de polarisation des électrodes fixes à une tension haute et une tension basse d'une source de tension d'alimentation. Le signal binaire obtenu en sortie de chaque logique est incrémenté ou décrémenté d'une unité à chaque série de phases de mesure, jusqu'à ce que la charge totale sur l'électrode mobile devienne nulle. Bien que la taille des composants électroniques et la consommation électrique soient réduites, les non-linéarités susmentionnées et les écarts de tension (offset) ne sont pas supprimés, ce qui est un inconvénient. De plus, le temps pour stabiliser le signal numérique de sortie pour chaque axe de mesure est relativement long, ce qui est un autre inconvénient.

Comme pour le précédent document, la demande de brevet WO 2008/107737 A1 décrit un circuit électronique d'interface d'un capteur de mesure d'une accélération. Un signal analogique de mesure est mémorisé à la suite d'un amplificateur à transfert de charges dans une phase d'un cycle de mesure suite à une polarisation des électrodes fixes des condensateurs. Le signal analogique est converti en un signal numérique mémorisé dans une logique du circuit électronique. Le signal numérique mémorisé est par la suite converti par un convertisseur numérique-analogique en un signal retour analogique sous forme de tension, qui est appliquée à toutes les électrodes du capteur dans une phase successive de chaque cycle de mesure. Dans un cycle de mesure, les électrodes fixes sont polarisées successivement par une première polarisation et par une seconde polarisation inverse à la première polarisation. Cela permet de supprimer les courants de fuite du circuit électronique. Par contre, beaucoup d'étapes sont nécessaires pour obtenir en sortie un signal de mesure d'un paramètre physique, ce qui constitue un inconvénient.

Dans la demande de brevet EP 2 343 507 A1, il est décrit un circuit électronique d'interface d'un capteur de mesure uniaxe ou triaxial. Un traitement numérique des signaux de mesure est effectué à la suite de l'amplificateur à transfert de charges dans une unité logique. Des signaux numériques de mesure suite à une polarisation positive et à une polarisation négative sont mémorisés dans des registres correspondants de l'unité logique. Un convertisseur numérique-analogique est également utilisé pour convertir les signaux numériques successivement pour chaque axe dans un cycle de mesure, en une tension aux électrodes du capteur. Pour obtenir des valeurs finales de mesure de l'accélération pour chaque axe, il est utilisé dans l'unité logique, tout d'abord un algorithme par dichotomie pour un certain nombre de cycles de mesure, avant de terminer par des étapes de sur-échantillonnage. Avec cet algorithme par dichotomie, la mesure débute toujours, lors de chaque conversion, à la moitié de la marge de mesure notamment à $V_{REG}/2$. Si une erreur survient lors de cette première mesure avec un grand pas de changement dans l'unité logique, la valeur finale au terme de tous les cycles de mesure, sera inévitablement fausse, ce qui constitue un inconvénient.

La demande de brevet EP 0 525 830 A1 décrit un transducteur à déplacement capacitif pour un joystick. Le transducteur comprend un agencement de condensateurs différentiels pour la mesure d'une variation capacitive des condensateurs selon au moins une direction. Les électrodes fixes des condensateurs sont alternativement polarisées par une tension de référence et une tension retour d'un convertisseur analogique alimenté par la tension de référence, et par des signaux en phase et en antiphase dans un modulateur provenant d'un oscillateur. Il n'est par contre pas prévu d'effectuer une mesure précise d'un paramètre physique en augmentant le rapport signal/bruit à basse tension.

L'invention a donc pour but de pallier aux inconvénients de l'état de la technique susmentionnés en proposant un procédé de mesure d'un paramètre physique au moyen d'un circuit électronique d'interface relié à un capteur capacitif, qui permet selon un nouveau schéma d'excitation des électrodes d'augmenter le rapport signal sur bruit à basse tension et de fournir rapidement des signaux de mesure précis en sortie.

A cet effet, l'invention concerne un procédé de mesure d'un paramètre physique au moyen d'un circuit électronique d'interface relié à un capteur capacitif, qui comprend les caractéristiques définies dans la revendication indépendante 1.

Des étapes particulières du procédé de mesure sont définies dans les revendications dépendantes 2 à 6.

Un avantage du procédé de mesure réside dans le fait qu'au moins un signal numérique de sortie d'une mesure d'un paramètre physique peut être fourni rapidement en sortie du circuit électronique. Grâce à une variation importante de la tension d'excitation appliquée à chaque électrode fixe des condensateurs d'une première phase à une seconde phase de mesure de la polarisation positive et/ou de la polarisation négative, le rapport signal sur bruit est amélioré sans augmentation du courant consommé et à faible tension d'alimentation.

La tension de polarisation initiale de l'une ou l'autre électrode fixe fournie par le convertisseur numérique-analogique n'est plus établie à la moitié de la marge de mesure, mais proche de la tension régulée d'alimentation dans la polarisation positive et proche de la tension basse dans la polarisation négative. Cela permet à chaque transition de phase, d'avoir une variation en tension tension sur chaque électrode fixe importante et ainsi une quantité de charges collectées proportionnelle au changement de tension sur chaque électrode fixe d'une phase à l'autre. Ceci permet d'avoir une meilleure sensibilité et un rapport signal sur bruit, qui peut être de l'ordre de 1.65 fois plus grand, que le rapport signal sur bruit d'un procédé de mesure de l'état de la technique.

A cet effet, l'invention concerne également un circuit électronique d'interface d'un capteur capacitif cité ci-devant pour la mise en oeuvre du procédé de mesure, qui comprend les caractéristiques définies dans la revendication indépendante 7.

Des formes d'exécution spécifiques du circuit électronique sont définies dans les revendications dépendantes 8 à 10.

Un avantage du circuit électronique d'interface d'un capteur capacitif réside dans le fait qu'il permet d'obtenir rapidement un ou plusieurs signaux numériques de mesure stabilisés en sortie grâce à un traitement numérique directement après l'amplificateur à transfert de charges. Ces signaux numériques de mesure sont traités dans l'unité logique. Deux signaux numériques dépendant d'une polarisation positive et d'une polarisation négative des électrodes fixes des condensateurs, peuvent être fournis. Ceci permet par combinaison des signaux numériques de supprimer tout écart de tension notamment des composants du circuit électronique.

Un autre avantage du circuit électronique d'interface d'un capteur physique réside dans le fait que le convertisseur numérique-analogique comprend un diviseur résistif, dont chaque noeud résistif est relié à un multiplexeur, qui est commandé successivement par chaque mot binaire stocké dans un registre correspondant de l'unité logique. Ce diviseur résistif permet au convertisseur numérique-analogique de générer une tension de référence Vref établie entre le milieu de la marge de mesure et la tension régulée d'alimentation. Une tension de référence inverse peut être générée par inversion de la connexion des bornes du diviseur résistif à connecter aux bornes d'une source de tension d'alimentation fournissant la tension régulée et la tension basse. Le signal numérique de la polarisation positive ou de la polarisation négative permet de commander au multiplexeur l'ajout ou le retrait d'une tension de mesure positive ou négative à la tension de référence ou à la tension de référence inverse, pour que le convertisseur fournisse une tension analogique à l'une ou l'autre électrode fixe des condensateurs dans chaque phase de mesure. De manière avantageuse, ce convertisseur numérique-analogique ne travaille plus autour du milieu de la marge de mesure, mais autour de la tension de référence pour la polarisation positive et autour de la tension de référence inverse pour la polarisation négative.

Les buts, avantages et caractéristiques du procédé de mesure d'un paramètre physique et le circuit électronique d'interface d'un capteur capacitif pour sa mise en oeuvre apparaîtront mieux dans la description suivante en regard des dessins sur lesquels :

- la figure 1 représente de manière simplifiée un circuit électronique d'interface relié à un capteur capacitif pour la mise en oeuvre du procédé de mesure d'un paramètre physique selon l'invention, et
- la figure 2 représente un diagramme temporel de signaux de tensions appliqués aux électrodes du capteur capacitif lié au circuit électronique d'interface du procédé de mesure selon l'invention.

Dans la description suivante, il sera fait référence principalement au nouveau procédé de mesure d'un paramètre physique au moyen d'un circuit électronique d'interface lié à un capteur capacitif pour fournir au moins un signal numérique de mesure en sortie du circuit électronique.

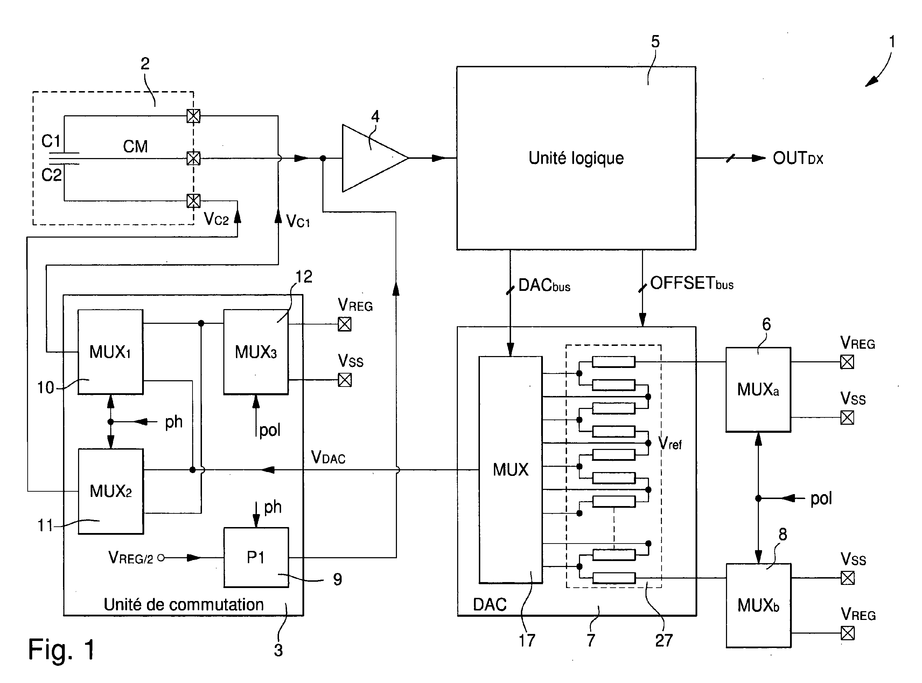

La figure 1 montre un schéma simplifié des différents composants du circuit électronique 1 d'interface d'un capteur capacitif 2 pour la mise en oeuvre du procédé de mesure d'un paramètre physique selon l'invention. Dans cette forme d'exécution, il est prévu de relier un capteur capacitif 2 du type MEMS à masse unique au circuit électronique 1. Ce capteur capacitif est donc composé d'une paire de condensateurs C1 et C2. Les deux condensateurs de la paire sont montés en différentiel. Une électrode commune CM de la paire de condensateurs peut se déplacer sous l'action notamment d'une force entre les deux électrodes fixes pour effectuer une mesure du paramètre physique. Bien entendu, il peut aussi être prévu d'utiliser un capteur capacitif du type triaxial, par exemple, avec une électrode commune pour les trois paires de condensateurs pour une mesure du paramètre physique selon trois axes X, Y et Z de mesure.

Le circuit électronique 1 peut fournir au moins un signal numérique de mesure, qui est relatif à un paramètre physique, tel qu'une accélération, une vitesse angulaire, une pression ou une force, en fonction du déplacement de l'électrode commune mobile entre les deux électrodes fixes. Dans le cas d'une mesure d'accélération, le circuit électronique peut être configuré pour fournir au moins un signal numérique de mesure entre des valeurs minimum et maximum d'accélération. Il peut être choisi par exemple de configurer le circuit électronique pour fournir des signaux numériques de mesure dans la gamme de -2g à +2g d'accélération. Une variation de tension de l'ordre de 3 à 20 mV peut être comptée pour 1 g d'accélération.

L'électrode commune mobile CM peut faire partie d'une armature du capteur maintenue élastiquement dans une position centrale au repos entre les deux électrodes fixes des condensateurs C1 et C2. Le circuit électronique 1 peut être alimenté par une source de tension d'alimentation continue non représentée. Cette source de tension d'alimentation fournit à une première borne une tension régulée haute $V_{REG}$ et à une seconde borne une tension basse $V_{SS}$. La tension basse peut être définie à 0 V, alors que la tension régulée haute peut être fixée à 1.65 V par exemple, voire légèrement inférieure. L'électrode fixe de chaque condensateur peut être polarisée dans une phase d'un cycle de mesure à deux phases ou quatre phases comme expliqué ci-après, soit à la tension haute $V_{REG}$, soit à la tension basse $V_{SS}$, soit à une tension analogique $V_{DAC}$ d'une précédente mesure ou d'une valeur initiale dans un mode de fonctionnement du circuit électronique.

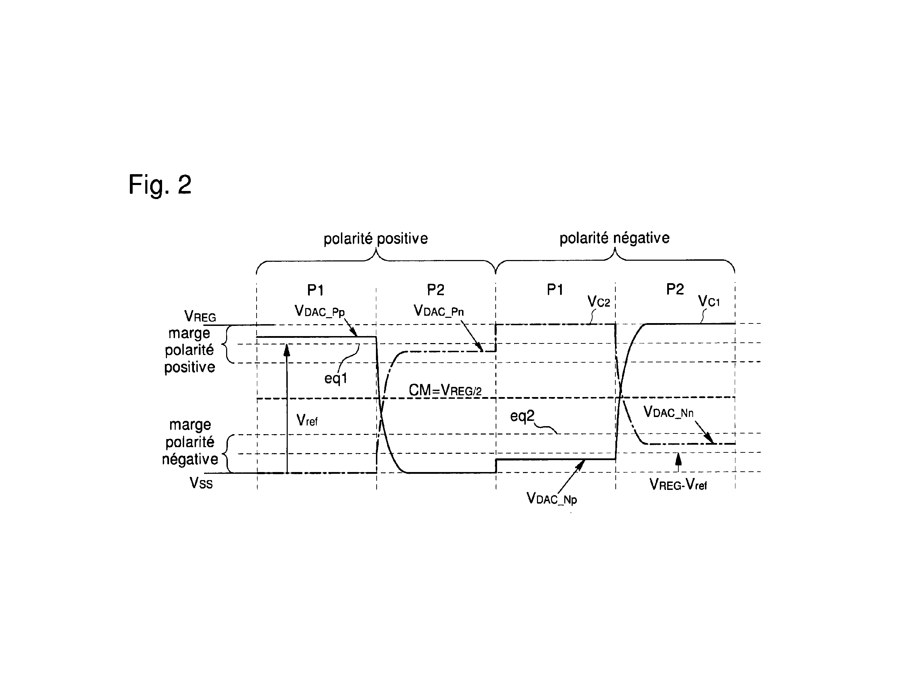

Selon le procédé de mesure d'un paramètre physique, le circuit électronique d'interface 1 peut être alimenté à une tension régulée minimum $V_{REG}$ en fonction du nouveau schéma d'excitation des électrodes du capteur capacitif expliqué en détail ci-après en référence à la figure 2. Chaque cycle de mesure peut être composé d'une première série de phases de mesure pour une polarisation définie positive des électrodes et d'une seconde série de phases de mesure pour une polarisation définie négative des électrodes. La première série de phases de mesure comprend une première phase P1 et une seconde phase P2 d'excitation des électrodes fixes des condensateurs C1 et C2 du capteur, alors que la seconde série de phases de mesure comprend une première phase P1 et une seconde phase P2 d'excitation successives inverse des électrodes fixes. Avec ce nouveau schéma d'excitation, il est prévu d'augmenter la variation de tension appliquée à chaque électrode fixe au passage de la première phase à la seconde phase pour chaque polarisation positive et négative, car les charges injectées sont proportionnelles à cette chute ou variation de tension. Cela permet donc d'avoir un rapport signal/bruit bien meilleur que celui de tout procédé de mesure de l'état de la technique, et sans besoin d'augmenter la tension régulée d'alimentation.

Le circuit électronique d'interface 1 comprend un amplificateur à transfert de charges du type comparateur 4, qui est relié directement à l'électrode mobile CM de la paire de condensateurs C1 et C2 ou par l'intermédiaire d'un condensateur supplémentaire disposé en série entre l'électrode mobile CM et l'entrée de l'amplificateur 4. Le circuit électronique comprend encore une unité de commutation 3, qui reçoit les tensions $V_{REG}$, $V_{SS}$ et $V_{DAC}$ à appliquer aux électrodes du capteur selon les phases de chaque cycle de mesure. La tension régulée $V_{REG}$ et la tension basse $V_{SS}$ sont appliquées alternativement aux électrodes fixes en fonction des phases de mesure. La tension analogique $V_{DAC}$, d'un convertisseur numérique-analogique 7 en contre-réaction, est appliquée alternativement aux électrodes fixes selon la phase de mesure et la polarisation positive ou négative comme expliqué en détail ci-après.

Pour la sélection des tensions à appliquer aux différentes électrodes du capteur capacitif 2, l'unité de commutation 3 peut comprendre un premier multiplexeur 10 $MUX_1$. Ce premier multiplexeur 10 reçoit en entrée la tension régulée $V_{REG}$ ou la tension $V_{SS}$ selon la polarisation positive ou négative de chaque cycle de mesure, et la tension analogique $V_{DAC}$ fournie par le convertisseur numérique-analogique 7. Ce premier multiplexeur 10 fournit en sortie la tension $V_{C1}$ à appliquer à l'électrode fixe du condensateur C1. L'unité de commutation 3 peut comprendre encore un second multiplexeur 11 $MUX_2$. Ce second multiplexeur 11 reçoit en entrée la tension régulée $V_{REG}$ ou la tension $V_{SS}$ selon la polarisation positive ou négative de chaque cycle de mesure, et la tension analogique $V_{DAC}$. Ce second multiplexeur 11 fournit en sortie la tension $V_{C2}$ à appliquer à l'électrode fixe du condensateur C2.

Les premier et second multiplexeurs 10 et 11 sont contrôlés par un signal de commande de phase ph. Lorsque ce signal de commande de phase ph est par exemple à l'état "1", le premier multiplexeur 10 fournit en sortie la tension analogique $V_{DAC}$, alors que le second multiplexeur 11 fournit en sortie la tension basse $V_{SS}$ dans la polarisation positive ou la tension régulée $V_{REG}$ dans la polarisation négative. Lorsque ce signal de commande de phase ph est par exemple à l'état "0", le premier multiplexeur 10 fournit en sortie la tension analogique $V_{SS}$ dans la polarisation positive ou la tension régulée $V_{REG}$ dans la polarisation négative, alors que le second multiplexeur 11 fournit en sortie la tension analogique $V_{DAC}$. Un troisième multiplexeur 12 $MUX_3$ peut être prévu pour recevoir en entrée la tension régulée $V_{REG}$ et la tension basse $V_{SS}$. Ce troisième multiplexeur 12 est commandé par un signal de commande de polarité pol, pour que la tension basse $V_{SS}$ soit fournie en sortie, quand le signal de commande de polarité pol est à l'état "0", et pour que la tension régulée $V_{REG}$ soit fournie en sortie, quand le signal de commande de polarité pol est à l'état "1 ".

L'amplificateur comparateur 4 est de conception très simple du type de celui décrit dans l'article intitulé "A 1 mV MOS Comparator" de la revue IEEE J. Solid-State Circuits, vol. SC-13. pp. 294-297 de juin 1978. Cet amplificateur comparateur 4 comprend généralement un condensateur en entrée relié à l'électrode commune CM, suivi d'étages amplificateurs pour fournir en sortie un signal de forme numérique en tout ou rien. Cet amplificateur à transfert de charges a un très haut gain. Le signal de sortie de l'amplificateur est à l'état "1 " proche de la tension régulée $V_{REG}$, quand la tension sur l'électrode mobile CM augmente par l'accumulation de charges positives dans les cycles de mesure. Par contre, le signal de sortie de l'amplificateur passe à l'état "0" proche de la tension basse $V_{SS}$, quand la tension sur l'électrode mobile CM diminue par l'accumulation de charges négatives dans les cycles de mesure.

Le circuit électronique 1 comprend encore une unité logique 5, qui comprend des moyens de mémorisation, dans lesquels sont mémorisés notamment différents paramètres de configuration. L'unité logique 5 du circuit électronique comprend encore un processeur non représenté, qui est cadencé par un signal d'horloge traditionnel, de manière à contrôler l'exécution de toutes les étapes nécessaires du procédé de mesure d'un paramètre physique, notamment d'une accélération. L'unité logique 5 comprend encore au moins deux registres non représentés pour stocker des signaux numériques sous forme de mots binaires de mesure. Un premier registre reçoit un premier signal numérique de mesure provenant de l'augmentation ou diminution de charges injectées sur l'électrode mobile CM suite à une polarisation définie positive (pol à "0") des électrodes fixes de la paire de condensateurs. Un second registre reçoit un second signal numérique de mesure provenant de l'augmentation ou diminution de charges injectées sur l'électrode mobile CM suite à une polarisation définie négative (pol à "1 ") des électrodes fixes C1 et C2 de la paire de condensateurs correspondante. La polarisation négative est simplement une polarisation inversée de la polarisation positive.

L'unité logique 5 fournit, par combinaison ou addition des deux registres dans un élément de combinaison non représenté, un signal numérique de sortie $OUT_{DX}$. Dans ce signal numérique de sortie par combinaison des signaux numériques de mesure des deux registres combinés, tout écart de tension (offset) a été avantageusement supprimé. L'unité logique 5 fournit également un mot binaire d'ajustage OFFSETbus sur 10 bits ou 11 bits au convertisseur numérique-analogique pour compenser tout écart de tension relatif au capteur MEMS en entrée.

Lors de chaque cycle de mesure, le premier signal numérique et le second signal numérique stockés dans un registre correspondant sont incrémentés ou décrémentés d'une certaine valeur numérique fonction d'un pas déterminé et programmé. L'incrémentation ou la décrémentation intervient jusqu'à la stabilisation de chaque signal numérique après un certain nombre de cycles successifs de mesure. A chaque cycle de mesure, les signaux numériques de mesure ou mots binaires DACbus stockés dans les registres, sont successivement fournis au convertisseur numérique-analogique 7 en tenant compte de la phase de mesure. Chaque signal numérique de mesure final fourni par le circuit électronique 1 est proportionnel pour deux condensateurs C1 et C2 à (Cs1-Cs2)/(Cs1+Cs2), où Cs1 est la valeur capacitive du condensateur C1, et Cs2 est la valeur capacitive du condensateur C2. Une fois que chaque signal numérique de mesure est stabilisé à une mesure finale du paramètre physique, tout écoulement de charges sur les deux condensateurs s'annule.

Le convertisseur numérique-analogique 7 comme expliqué ci-après, permet d'opérer une conversion des signaux numériques en une tension analogique $V_{DAC}$ à fournir aux électrodes fixes respectivement selon la phase et la polarisation dans chaque cycle de mesure. Dans la tension analogique $V_{DAC}$ et pour la polarisation positive, une tension de référence Vref générée dans le convertisseur numérique-analogique 7 est encore ajoutée à une tension positive ou négative Vp convertie provenant d'un premier signal numérique de mesure de l'unité logique 5. Dans la tension analogique $V_{DAC}$ et pour la polarisation négative, une tension de référence inverse $V_{REG}$-Vref est aussi ajoutée à une tension positive ou négative Vn convertie provenant d'un second signal numérique de mesure de l'unité logique 5.

Cette tension de référence Vref est générée par un diviseur résistif 27 du convertisseur numérique-analogique 7. Ce diviseur résistif peut compter plus de 1000 résistances de même valeur résistive, bien appariées, par exemple 1536 résistances unitaires. Cette tension de référence Vref est choisie entre une valeur de tension de $V_{REG}$/2 et $V_{REG}$ pour augmenter le rapport signal/bruit. Cette tension de référence peut être choisie de préférence le plus proche possible de la tension régulée $V_{REG}$, et au moins 1.5 fois plus élevée que la valeur de tension $V_{REG}$/2. Cette tension de référence peut être choisie par exemple à une valeur de l'ordre de 1.36 V ou 1.4 V pour tenir compte également de tout écart d'offset lié au capteur capacitif MEMS.

Il est à noter qu'au début de toute mesure chaque mot binaire DACbus fourni est par exemple centré au milieu de la gamme de mesure. En passant par le convertisseur numérique-analogique, cela signifie que la gamme de mesure dans la polarisation positive se situe autour de la tension de référence Vref, alors que la gamme de mesure dans la polarisation négative se situe autour de la tension de référence inverse $V_{REG}$-Vref. Au début de chaque mesure, les mots binaires des registres, qui sont fournis successivement au convertisseur numérique-analogique, peuvent être réinitialisés au milieu de la marge de mesure, c'est-à-dire à 512 pour une marge numérique de 0 à 1023 (10 bits). Le milieu de la marge de mesure correspond à un mot binaire de référence dans l'unité logique. Cependant en fournissant le mot binaire de valeur à 512 au multiplexeur 17 du convertisseur numérique-analogique 7, ledit multiplexeur fournit en sortie, comme tension analogique $V_{DAC}$, soit la tension de référence Vref, soit la tension de référence inverse $V_{REG}$-Vref en fonction de la polarisation.

De manière à générer la tension de référence Vref et la tension de référence inverse $V_{REG}$-Vref du convertisseur numérique-analogique 7, il est prévu un premier multiplexeur d'alimentation 6 $MUX_a$ et un second multiplexeur d'alimentation 8 $MUX_b$. Les premier et second multiplexeurs 6 et 8 sont prévus pour recevoir en entrée la tension régulée $V_{REG}$ et la tension basse $V_{SS}$. Ces multiplexeurs d'alimentation 6 et 8 sont commandés par un signal de commande de polarité pol.

Quand ce signal de commande de polarité pol est à l'état "0" pour la polarisation positive, le premier multiplexeur d'alimentation 6 fournit la tension régulée $V_{REG}$ en sortie à une première borne du diviseur résistif 27, alors que le second multiplexeur d'alimentation 8 fournit la tension basse $V_{SS}$ à une seconde borne du diviseur résistif pour alimenter ledit diviseur résistif 27. Ainsi la tension de référence Vref est définie dans le convertisseur. Quand ce signal de commande de polarité pol est à l'état "1 pour la polarisation négative, le premier multiplexeur d'alimentation 6 fournit la tension basse $V_{SS}$ en sortie, alors que le second multiplexeur d'alimentation 8 fournit la tension régulée $V_{REG}$ pour alimenter inversement le diviseur résistif 27. Ainsi la tension de référence inverse $V_{REG}$-Vref est définie dans le convertisseur.

Le procédé de mesure d'un paramètre physique au moyen d'un circuit électronique 1 relié à un capteur capacitif 2 est maintenant expliqué de manière plus détaillée en référence à la figure 2. Un nouveau schéma d'excitation est proposé avec le but d'augmenter la chute ou variation de tension appliquée à chaque électrode fixe des condensateurs au passage de chaque phase pour la polarisation positive, et pour la polarisation négative. La grande chute de tension au passage de la première phase P1 à la seconde phase P2 pour la polarisation positive des électrodes fixes et pour la polarisation négative des électrodes fixes, qui est l'inverse de la polarisation positive, permet d'avoir des charges injectées sur l'électrode mobile CM proportionnelles à cette grande chute de tension.

Les deux premières phases du cycle de mesure sont effectuées par exemple avec la polarisation définie positive des électrodes fixes C1 et C2, alors que les deux phases successives sont effectuées avec la polarisation négative des électrodes fixes. La durée de chaque phase peut être de l'ordre de 2 $\mu$s. Cependant il peut aussi être effectué la polarisation négative avant la polarisation positive pour chaque cycle de mesure.

Il peut être prévu de fixer également une tension sur l'électrode mobile CM à une valeur comprise entre $V_{REG}$ et $V_{SS}$, de préférence à $V_{REG}/2$. Cette tension fixée sur l'électrode mobile CM peut être appliquée dans chaque première phase P1 de la polarisation positive et de la polarisation négative. Pour ce faire, l'unité de commutation 3 comprend encore un interrupteur 9, qui reçoit en entrée une tension centrée à $V_{REG}/2$ et est commandé par le signal de commande de phase ph de manière à appliquer à l'électrode CM cette tension centrée dans chaque première phase P1. Cette tension centrée à $V_{REG}/2$ peut être obtenue au noeud de connexion de deux résistances identiques d'un diviseur résistif connecté entre $V_{REG}$ et $V_{SS}$. Ceci peut être une condition pour pouvoir supprimer le premier ordre des forces électrostatiques appliquées à l'électrode mobile CM.

Dans la première phase P1 de la polarisation positive, la tension $V_{C1}$ appliquée à l'électrode fixe C1, est égale à $V_{DAC\_Pp}$, alors que la tension $V_{C2}$ appliquée à l'électrode fixe C2, est égale à $V_{SS}$. Dans la seconde phase P2 de la polarisation positive, la tension $V_{C1}$ appliquée à l'électrode fixe C1, est égale à $V_{SS}$, alors que la tension $V_{C2}$ appliquée à l'électrode fixe C2, est égale à $V_{DAC\_PN}$. Dans la première phase P1 de la polarisation négative, la tension $V_{C1}$ appliquée à l'électrode fixe C1, est égale à $V_{DAC-Np}$, alors que la tension $V_{C2}$ appliquée à l'électrode fixe C2, est égale à $V_{REG}$. Finalement, dans la seconde phase P2 de la polarisation négative, la tension $V_{C1}$ appliquée à l'électrode fixe C1, est égale à $V_{REG}$, alors que la tension $V_{C2}$ appliquée à l'électrode fixe C2, est égale à $V_{DAC\_NN}$.

La tension $V_{DAC}$, fournie par le convertisseur numérique-analogique 7 dans chaque phase, vaut donc successivement $V_{DAC\_Pp}$, $V_{DAC-Pn}$, $V_{DAC\_Np}$ et $V_{DAC\_Nn}$. La tension $V_{DAC\_Pp}$ correspond à une valeur de tension Vp additionnée ou soustraite d'une tension de référence Vref s'il y a par exemple une accélération mesurée. Cette valeur de tension Vp est représentative du premier mot binaire ou signal numérique de mesure stocké dans un des registres de l'unité logique, de préférence par rapport à une valeur initiale de repos sans accélération. Cette valeur initiale, qui représente un mot binaire de référence initial, peut être définie dans l'unité logique comme une valeur centrée au milieu de la marge de mesure, c'est-à-dire à une valeur numérique égale à 512 pour une marge numérique de 0 à 1023 (10 bits).

Le premier mot binaire DACbus est fourni à un multiplexeur 17 du convertisseur numérique-analogique 7 de la figure 1, qui est relié à chaque noeud des résistances du diviseur résistif 27. En fonction de la valeur du premier mot binaire dans la polarisation positive, la tension Vp est ajoutée ou soustraite de la tension de référence Vref de repos pour déterminer la tension $V_{DAC\_Pp}$ fournie à l'électrode fixe C1. La tension $V_{DAc\_Pn}$ correspond à la tension Vref à laquelle en fonction de la valeur d'un second mot binaire dans la polarisation positive, la tension Vp est soustraite ou ajoutée à la tension de référence Vref, inversement à la tension $V_{DAC\_Pp}$. Le registre de la polarisation positive dans l'unité logique peut mémoriser un premier mot binaire de la première phase P1 de manière à commander au convertisseur par exemple la fourniture en sortie de la tension Vref+Vp ($V_{DAC-Pp}$) à fournir pour l'électrode fixe du premier condensateur C1. L'unité logique détermine le second mot binaire, qui est complémentaire au premier mot binaire. Ce second mot binaire est fourni au multiplexeur du convertisseur de manière qu'il fournisse en sortie la tension Vref-Vp ($V_{DAC\_Pn}$) dans la seconde phase P2 à l'électrode fixe du second condensateur C2. Ce second mot binaire est l'inverse du premier mot binaire dudit registre par rapport à un mot binaire de référence, qui est de préférence à la valeur centrée définie dans l'unité logique. Pour chaque polarisation positive, l'écart de variation de tension sur les deux électrodes fixes de la phase P1 à la phase P2 se situe à deux fois la valeur de tension Vp.

Pour la polarisation négative, la tension $V_{DAC\_NP}$ correspond à une valeur de tension Vn additionnée ou soustraite d'une tension de référence inverse $V_{REG}$-Vref s'il y a par exemple une accélération mesurée. Cette valeur de tension Vn est représentative d'un troisième mot binaire ou signal numérique de mesure stocké dans un des registres de l'unité logique, de préférence par rapport à une valeur initiale de repos sans accélération. Le troisième mot binaire est fourni au convertisseur pour qu'il fournisse dans la première phase P1 la tension $V_{DAC\_Pp}$, qui vaut par exemple ($V_{REG}$-Vref)-Vn. L'unité logique détermine également un quatrième mot binaire, qui est complémentaire au troisième mot binaire à fournir au convertisseur. Ce quatrième mot binaire est l'inverse du troisième mot binaire par rapport au mot binaire de référence ou à la valeur centrée définie dans l'unité logique. Le quatrième mot binaire permet au convertisseur de fournir la tension $V_{DAC\_Nn}$, qui vaut par exemple ($V_{REG}$-Vref)+Vn, dans la seconde phase P2. Pour chaque polarisation négative, l'écart de variation de tension sur les deux électrodes fixes de la phase P1 à la phase P2 se situe à deux fois la valeur de tension Vn.

S'il n'y a aucune accélération mesurée, toutes les tensions $V_{DAC}$ fournies dans chaque phase des cycles de mesure, sont égales à la tension de référence Vref pour la polarisation positive et à la tension de référence inverse $V_{REG}$-Vref pour la polarisation négative. La valeur Vref est représentée par la droite eq1 pour la polarisation positive, et la valeur $V_{REG}$-Vref est représentée par la droite eq2 pour la polarisation négative. La tension de référence Vref est déterminée pour se situer entre $V_{REG}/2$ et $V_{REG}$ et de préférence à proximité de $V_{REG}$. Il peut être sélectionné dans l'agencement du diviseur résistif 27 et du multiplexeur 17, que cette tension de référence Vref est fournie à une valeur par exemple égale à 1.36 V, alors que la tension régulée peut être à 1.65 V. Dans cette condition, la tension de référence inverse $V_{REG}$-Vref peut être d'une valeur par exemple égale à 0.29 V.

Cette tension de référence Vref est choisie proche de $V_{REG}$, tout en laissant une marge de variation de la polarisation positive de mesure du paramètre physique, tel qu'une accélération. Cette valeur de tension Vref égale à 1.36 V est définie pour tenir compte de toute compensation possible d'offset du capteur MEMS, qui peut être de l'ordre de 12.3 g et un gain du capteur MEMS, qui peut être 1.5 fois plus grand que le gain nominal.

La sensibilité de mesure est ainsi nettement augmentée par rapport à une mesure effectuée selon un procédé de mesure de l'état de la technique. La variation en tension de la phase P1 à la phase P2 sur chaque électrode fixe des condensateurs est bien supérieure à $V_{REG}$/2. Dans ce cas de figure, la mesure débute pour chaque électrode fixe des condensateurs à la tension de référence Vref dans les phases P1 et P2 de la polarisation positive, alors que précédemment la mesure débutait à une valeur à $V_{REG}$/2 égale à 0.825 V. La sensibilité de la mesure de la présente invention est donc de 1.65 (1.36V/0.825V) fois plus grande que la sensibilité d'un procédé de mesure de l'état de la technique.

Dans la première phase P1 et la seconde phase P2 pour la polarisation positive pol0 et la polarisation négative pol1 des électrodes fixes, des forces électrostatiques Fel1 et Fel2 sont appliquées à l'électrode commune CM. Une force électrostatique Fel1 entre l'électrode fixe du premier condensateur C1 et l'électrode mobile CM est appliquée, alors qu'une force électrostatique Fel2 entre l'électrode fixe du second condensateur C2 et l'électrode mobile CM est appliquée. Il peut être défini une moyenne de ces 8 forces électrostatiques pour chaque cycle de mesure. Cette moyenne des forces électrostatiques peut être exprimée par la formule suivante :

$$Fel_{mean}= (Fel1_{P1\_pol0}+Fel2_{P1\_pol0}+Fel1_{P2\_pol0}+Fel2_{P2\_pol0}+Fel1_{P1\_pol1}+$$
$$Fel2_{P1\_pol1}+Fel1_{P2\_pol1}+Fel2_{P2\_pol1})/8$$

La force électrostatique Fel1 peut être écrite par exemple comme la dérivée de l'énergie capacitive le long du degré liberté :

$$Fel1 = \partial E_{capacitive}/\partial x = 0.5 \cdot (\varepsilon_0 \cdot S/x^2) \cdot (u1-um)^2$$

où $\varepsilon_0$ est une constante de la permittivité du vide, S est la surface de l'électrode, u1 et um sont les potentiels électrostatiques sur les électrodes C1 et CM, x la distance mobile entre les électrodes C1 et CM.

La force électrostatique appliquée à CM peut donc être écrite :

$$Fel_{mean}= \varepsilon_0 \cdot S/8 \cdot ((V_{REG}^2/2) \cdot ((1/(D0/2-Dx))^2-(1/(D0/2+Dx))^2)+$$
$$2 \cdot (((V_{REG}/2-Vref-V_{DAC})/(D0/2-Dx))^2-((V_{REG}/2-Vref+$$
$$V_{DAC})/(D0/2+Dx))^2)$$

où Dx est la variation de x, qui est petite par rapport à D0, qui est la distance relâchée entre les électrodes CM et C2. Il est assumé que la valeur d'état stable de $V_{DAC}$ correspond à une charge injectée égale à 0 sur l'électrode CM durant la transition de la phase P1 à la phase P2. Cette valeur à l'état stable de $V_{DAC}$ peut donc être approximée comme suit :

$$V_{DAC} = (Cs1-Cs2)/(Cs1+Cs2) \cdot Vref = (Dx/x) \cdot Vref$$

Ainsi selon la supposition précédente, les forces électrostatiques appliquées sur l'électrode mobile CM sont annulées dans leur moyenne du premier ordre, lorsque la distance Dx est petite comparativement à la distance D0. Cela signifie que l'accélération mesurée est petite. Il est par contre à noter que les forces électrostatiques restantes du second ordre peuvent induire une petite non linéarité, qui est dans une marge acceptable et sans nuire à la meilleure sensibilité obtenue par le procédé de mesure de la présente invention.

Pour la mesure dans les deux phases P1 et P2 de la polarisation positive et dans le cas où l'électrode mobile s'est déplacée en direction de l'électrode fixe du condensateur C2, cela donne une valeur capacitive Cs2 plus grande que la valeur capacitive Cs1 du premier condensateur C1. Dans ces conditions, la tension Vp est ajoutée dans la première phase P1 à la tension de référence Vref, alors que la tension Vp est soustraite de la tension de référence Vref dans la seconde phase P2. Cette tension de mesure Vp croît depuis une valeur initiale à 0 V, ce qui correspond par exemple à un mot binaire DACbus fixé à 1000000000 (10 bits) ou 10000000000 (11 bits) fourni au convertisseur numérique-analogique, jusqu'à une valeur finale de mesure du paramètre physique après un certain nombre de cycles successifs de mesure. Il peut être prévu par exemple 8, 12, 16 ou 32 cycles de mesure pour obtenir une valeur finale de mesure, mais de préférence peu de cycles sont suffisants avec ce nouveau schéma d'excitation des électrodes fixes.

La tension $V_{DAC-Pp}$ vaut donc Vref+Vp, qui est la tension $V_{C1}$ appliquée à l'électrode fixe du condensateur C1, alors que la tension $V_{DAC\_Pn}$ vaut Vref-Vp, qui est la tension $V_{C2}$ appliquée à l'électrode fixe du condensateur C2. Au passage de la première phase P1 à la seconde phase P2 de la polarisation positive, la variation $\Delta V_{C1}$ de la tension sur l'électrode fixe du premier condensateur C1 est égale à Vref+Vp, alors que la variation $\Delta V_{C2}$ de la tension sur l'électrode fixe du second condensateur C2 est égale à Vref-Vp. Selon l'équation $\Delta Q_{CM} = Cs1 \cdot \Delta V_{C1} - Cs2 \cdot \Delta V_{C2}$, l'écart de la quantité de charges $\Delta Q_{CM}$ injectées sur l'électrode mobile CM devient égal à 0, une fois que le signal numérique de mesure de la polarisation positive se stabilise à une valeur finale.

Pour la polarisation négative, qui est l'inverse de la polarisation positive, une tension de mesure Vn est ajoutée ou soustraite de la tension de référence inverse $V_{REG}$-Vref dans la phase P1 et la phase P2. Si la capacité Cs2 du second condensateur C2 est plus grande que la capacité Cs1 du premier condensateur C1, la tension Vn est soustraite de la tension de référence inverse $V_{REG}$-Vref dans la première phase P1, alors que la tension Vn est ajoutée à la tension de référence inverse $V_{REG}$-Vref dans la seconde phase P2. Comme précédemment indiqué, cette tension de mesure Vn décroît depuis une valeur initiale à 0 V, jusqu'à une valeur finale de mesure du paramètre physique après un certain nombre de cycles successifs de mesure. La tension $V_{DAC\_NP}$ vaut donc ($V_{REG}$-Vref)-Vn, qui est la tension $V_{C1}$ appliquée à l'électrode fixe du condensateur C1, alors que la tension $V_{DAC\_Nn}$ vaut ($V_{REG}$-Vref)+Vn, qui est la tension $V_{C2}$ appliquée à l'électrode fixe du condensateur C2. La tension Vref+Vn correspond à la variation en tension $\Delta V_{C1}$ sur l'électrode fixe du premier condensateur C1 lors du passage de la première phase P1 à la seconde phase P2. La tension Vref-Vn correspond à la variation en tension $\Delta V_{C2}$ sur l'électrode fixe du second condensateur C2 lors du passage de la première phase P1 à la seconde phase P2. Pour la polarisation négative, l'écart de la quantité de charges $\Delta Q_{CM}$ injectées sur l'électrode mobile CM devient aussi égal à 0, une fois que le signal numérique de mesure de la polarisation négative se stabilise à une valeur finale. Dans un circuit électronique linéaire, la tension Vn peut correspondre à la tension Vp.

Bien entendu dans le cas où l'électrode mobile CM se déplace en direction de l'électrode fixe du premier condensateur C1, la valeur capacitive Cs1 devient plus grande que la valeur capacitive Cs2 du second condensateur C2. Dans ces conditions, la tension $V_{DAC\_Pp}$ vaut donc Vref-Vp, qui est la tension $V_{C1}$ appliquée à l'électrode fixe du condensateur C1 dans la première phase P1, alors que la tension $V_{DAC\_Pn}$ vaut Vref+Vp, qui est la tension $V_{C2}$ appliquée à l'électrode fixe du condensateur C2 dans la seconde phase P2 pour la polarisation positive. La tension $V_{DAC\_Np}$ vaut donc ($V_{REG}$-Vref)+Vn, qui est la tension $V_{C1}$ appliquée à l'électrode fixe du condensateur C1 dans la première phase P1, alors que la tension $V_{DAC-Nn}$ vaut ($V_{REG}$-Vref)-Vn, qui est la tension $V_{C2}$ appliquée à l'électrode fixe du condensateur C2 dans la seconde phase P2 pour la polarisation négative.

A partir de la description qui vient d'être faite, de multiples variantes de réalisation du procédé de mesure d'un paramètre physique et du circuit électronique d'interface du capteur capacitif pour sa mise en oeuvre peuvent être conçues par l'homme du métier sans sortir du cadre de l'invention définie par les revendications. Il peut être envisagé de modifier la durée de chaque phase l'une par rapport à l'autre ou la durée de chaque cycle durant les opérations de mesure du paramètre physique, ainsi que le nombre de cycles de mesure successifs pour chaque conversion de mesure. Il peut être prévu de modifier l'ordre des polarisations positive et négative dans chaque cycle de mesure.

**Revendications**

1. Procédé de mesure d'un paramètre physique au moyen d'un circuit électronique (1) d'interface relié à un capteur capacitif (2), qui comprend au moins un premier et un second condensateurs (C1, C2) montés en différentiel, dont une électrode commune (CM) est susceptible de se déplacer par rapport à chaque électrode fixe des deux condensateurs pour modifier la valeur capacitive de chaque condensateur lors de la mesure du paramètre physique, ledit circuit électronique comprenant un amplificateur à transfert de charges (4), qui est connecté à l'électrode commune (CM), une unité logique (5) reliée à la sortie de l'amplificateur pour un traitement numérique de l'information fournie par l'amplificateur et la fourniture d'au moins un signal numérique de mesure, un convertisseur numérique-analogique (7) pour fournir une tension de mesure ($V_{DAC}$), qui est définie sur la base d'une conversion d'au moins un premier mot binaire ou un second mot binaire (DACbus) relatifs au signal numérique de mesure, une unité de commutation (3) pour fournir alternativement à chaque électrode fixe des deux condensateurs, la tension de mesure ($V_{DAC}$), et une tension régulée ($V_{REG}$) ou une tension basse ($V_{SS}$) d'une source de tension d'alimentation, le procédé comprenant dans chaque cycle successif de mesure des étapes consistant à :

a) dans une première phase (P1), polariser l'électrode fixe du premier condensateur (C1) par l'intermédiaire de l'unité de commutation (3) avec une première tension de mesure ($V_{DAC}$) fournie par le convertisseur numérique-analogique (7), et l'électrode fixe du second condensateur (C2) avec la tension basse ($V_{SS}$) pour une polarisation définie positive des électrodes ou la tension régulée ($V_{REG}$) pour une polarisation définie négative des électrodes, la première tension de mesure étant définie sur la base du premier mot binaire relatif au signal numérique de mesure d'un précédent cycle ou d'un mot binaire de référence initial fourni par l'unité logique (5), et en fonction d'une tension de référence (Vref) générée dans le convertisseur numérique-analogique (7), pour une polarisation positive, ou en fonction d'une tension de référence inverse générée dans le convertisseur numérique-analogique (7), pour une polarisation négative, la tension de référence inverse correspondant à la différence entre la tension régulée ($V_{REG}$) et la tension de référence (Vref), qui est définie de valeur plus grande que la moitié de la tension régulée ($V_{REG}$),

b) dans une seconde phase (P2), polariser l'électrode fixe du second condensateur (C2) par l'intermédiaire de l'unité de commutation (3) avec une seconde tension de mesure ($V_{DAC}$) fournie par le convertisseur numérique-analogique (7), et l'électrode fixe du premier condensateur (C1) avec la tension basse ($V_{SS}$) ou la tension régulée ($V_{REG}$), la seconde tension de mesure étant définie sur la base du second mot binaire relatif au signal numérique de mesure ou du mot binaire de référence initial fourni par l'unité logique (5), et en fonction de la tension de référence (Vref), si la polarisation positive est sélectionnée dans la première phase (P1), ou en fonction de la tension de référence inverse, si la polarisation négative est sélectionnée dans la première phase (P1), le second mot binaire étant défini dans l'unité logique (5) comme l'inverse du premier mot binaire par rapport au mot binaire de référence, et

c) incrémenter ou décrémenter d'un pas déterminé dans l'unité logique (5), le signal numérique de mesure en fonction de l'augmentation ou la diminution de la quantité de charges injectées sur l'électrode mobile (CM) sur la base de la variation en tension sur l'électrode fixe du premier condensateur (C1) et de la variation en tension sur l'électrode fixe du second condensateur (C2) au passage de la première phase (P1) à la seconde phase (P2),

le procédé étant **caractérisé en ce que** chaque cycle de mesure comprend une première série de phases de mesure avec une première phase (P1) et une seconde phase (P2) selon les étapes a) et b) avec une polarisation positive ou négative des électrodes fixes des condensateurs (C1, C2) pour la fourniture d'un premier signal numérique de mesure dans l'unité logique (5), et une seconde série de phases de mesure avec une première phase (P1) et une seconde phase (P2) selon les étapes a) et b) avec une polarisation des électrodes fixes inverse de la première série de phases de mesure pour la fourniture d'un second signal numérique de mesure dans l'unité logique (5).

2. Procédé de mesure selon la revendication 1, pour lequel l'unité logique (5) comprend un premier registre pour mémoriser le premier signal numérique de mesure, et un second registre pour mémoriser le second signal numérique de mesure, **caractérisé en ce que** chaque mesure du paramètre physique débute sur la base d'une valeur numérique finale de chaque signal numérique mémorisé dans le premier registre et le second registre d'une précédente mesure.

3. Procédé de mesure selon l'une des revendications 1 et 2, **caractérisé en ce que** dans chaque première phase (P1) de cycles de mesure, l'électrode mobile (CM) des premier et second condensateurs (C1, C2) est polarisée à une tension comprise entre la tension basse ($V_{SS}$) et la tension régulée ($V_{REG}$).

4. Procédé de mesure selon la revendication 3, **caractérisé en ce que** l'électrode mobile (CM) des premier et second condensateurs (C1, C2) est polarisée dans chaque première phase (P1) à une tension égale à la moitié de la tension régulée ($V_{REG}$).

5. Procédé de mesure selon la revendication 1, pour lequel la tension de référence (Vref) ou la tension de référence inverse sont générées dans le convertisseur numérique-analogique (7) au moyen d'un diviseur résistif (27) connecté dans une première direction à la source de tension d'alimentation entre la tension régulée ($V_{REG}$) et la tension basse ($V_{SS}$) pour définir la polarisation positive avec la tension de référence (Vref), et connecté dans une seconde direction inverse de la première direction à la source de tension d'alimentation pour définir la polarisation négative avec la tension de référence inverse, chaque noeud des résistances du diviseur résistif étant relié à un multiplexeur (17) commandé par le premier mot binaire ou le second mot binaire de manière à fournir par l'intermédiaire de l'unité de commutation (3), la première tension de mesure à l'électrode fixe du premier condensateur (C1) dans la première phase (P1), et la seconde tension de mesure à l'électrode fixe du second condensateur (C2) dans la seconde phase (P2).

6. Procédé de mesure selon la revendication 5, pour lequel la tension de référence (Vref) est établie dans le convertisseur numérique-analogique (7) à une valeur supérieure ou égale à 1.5 fois la moitié de la tension régulée ($V_{REG}$), et pour lequel le mot binaire de référence correspond à une valeur numérique dans l'unité logique (5) du milieu de la marge de mesure pour être fourni au début de cycles de mesure au multiplexeur (17) du convertisseur numérique-analogique (7), afin de fournir une tension de mesure ($V_{DAC}$) égale à la tension de référence (Vref) pour une polarisation positive des électrodes fixes et une tension de référence inverse pour une polarisation négative des électrodes fixes.

7. Circuit électronique (1) d'interface d'un capteur capacitif, qui comprend une paire de condensateurs (C1, C2) montés en différentiel, le circuit électronique étant adapté à mettre en oeuvre toutes les étapes du procédé de mesure selon la revendication 5,

le circuit électronique comprenant un amplificateur à transfert de charges (4) pour être connecté à l'électrode commune (CM) des condensateurs, une unité logique (5) reliée à la sortie de l'amplificateur pour un traitement numérique de l'information fournie par l'amplificateur et la fourniture d'au moins un signal numérique de mesure, un convertisseur numérique-analogique (7) pour fournir une tension de mesure ($V_{DAC}$), qui est définie sur la base d'une conversion d'au moins un premier mot binaire ou un second mot binaire (DACbus) relatifs au signal numérique de mesure, une unité de commutation (3) capable de fournir alternativement à chaque électrode fixe des deux condensateurs, la tension de mesure ($V_{DAC}$), et une tension régulée ($V_{REG}$) ou une tension basse ($V_{SS}$) d'une source de tension d'alimentation,

caractérisé en ce que le convertisseur numérique-analogique (7) comprend un diviseur résistif (27) pour la génération d'une tension de référence (Vref) pour une polarisation positive des électrodes fixes des condensateurs, ou d'une tension de référence inverse pour une polarisation négative des électrodes fixes, chaque noeud des résistances du diviseur résistif (27) étant relié à un multiplexeur (17), qui peut être commandé par le premier mot binaire ou le second mot binaire pour permettre au convertisseur numérique-analogique (7) de fournir une première tension de mesure ($V_{DAC}$) sur la base du premier mot binaire et de la tension de référence (Vref) ou de la tension de référence inverse, et une seconde tension de mesure sur la base du second mot binaire et de la tension de référence (Vref) ou de la tension de référence inverse.

8. Circuit électronique (1) selon la revendication 7, caractérisé en ce que le diviseur résistif (27) du convertisseur numérique-analogique (7) comprend plus de 1000 résistances appariées de même valeur résistive, par exemple 1536 résistances unitaires.

9. Circuit électronique (1) selon la revendication 7, caractérisé en ce que l'unité logique (5) comprend un premier registre pour mémoriser un premier signal numérique de mesure d'une polarisation positive des électrodes fixes des condensateurs (C1, C2), et un second registre pour mémoriser un second signal numérique de mesure d'une polarisation négative des électrodes fixes des condensateurs (C1, C2), et en ce que l'unité logique (5) est prévue pour combiner ou additionner le premier signal numérique de mesure mémorisé dans le premier registre et le second signal numérique de mesure mémorisé dans le second registre pour la fourniture d'un signal numérique de sortie ($OUT_{DX}$).

10. Circuit électronique (1) selon la revendication 7, caractérisé en ce qu'il comprend un premier multiplexeur d'alimentation (6) et un second multiplexeur d'alimentation (8), les premier et second multiplexeurs d'alimentation (6, 8) étant prévus pour recevoir en entrée la tension régulée ($V_{REG}$) et la tension basse ($V_{SS}$), en ce que la sortie du premier multiplexeur d'alimentation (6) est relié à une première borne du diviseur résistif (27), en ce que la sortie du second multiplexeur d'alimentation (8) est relié à une seconde borne du diviseur résistif (27), et en ce que les premier et second multiplexeurs (6, 8) sont commandés par un signal de commande de polarité (pol) de manière à fournir la tension régulée ($V_{REG}$) à la première borne du diviseur résistif (27) et la tension base ($V_{SS}$) à la seconde borne du diviseur résistif (27), pour la génération de la tension de référence (Vref) d'une polarisation positive, et à fournir la tension basse ($V_{SS}$) à la première borne du diviseur résistif (27) et la tension régulée ($V_{REG}$) à la seconde borne du diviseur résistif (27), pour la génération de la tension de référence inverse d'une polarisation négative.

**Patentansprüche**

1. Verfahren zum Messen eines physikalischen Parameters mittels einer elektronischen Schnittstellenschaltung (1), die mit einem kapazitiven Sensor (2) verbunden ist, der wenigstens einen ersten und einen zweiten Kondensator (C1, C2) enthält, die differentiell geschaltet sind und wovon eine gemeinsame Elektrode (CM) sich in Bezug auf jede feste Elektrode der zwei Kondensatoren verlagern kann, um den Kapazitätswert jedes Kondensators bei der Messung des physikalischen Parameters zu modifizieren, wobei die elektronische Schaltung einen Ladungsübertragungsverstärker (4), der mit der gemeinsamen Elektrode (CM) verbunden ist, eine Logikeinheit (5), die mit dem Ausgang des Verstärkers verbunden ist, um die von dem Verstärker gelieferte Information digital zu verarbeiten und um wenigstens ein digitales Messsignal zu liefern, einen Digital/Analog-Umsetzer (7), um eine Messspannung

($V_{DAC}$) zu liefern, die anhand einer Umsetzung wenigstens eines ersten Binärworts oder eines zweiten Binärworts (DACbus), die auf das digitale Messsignal bezogen sind, definiert ist, eine Kommutationseinheit (3), um abwechselnd an jede feste Elektrode der zwei Kondensatoren die Messspannung ($V_{DAC}$) und entweder eine regulierte Spannung ($V_{REG}$) oder eine Niederspannung ($V_{SS}$) einer Versorgungsspannungsquelle zu liefern, umfasst,
wobei das Verfahren in jedem aufeinander folgenden Messzyklus die folgenden Schritte umfasst, die darin bestehen:

a) in einer ersten Phase (P1) die feste Elektrode des ersten Kondensators (C1) über die Kommutationseinheit (3) mit einer ersten Messspannung ($V_{DAC}$), die von dem Digital/Analog-Umsetzer (7) geliefert wird, vorzuspannen und die feste Elektrode des zweiten Kondensators (C2) mit der Niederspannung ($V_{SS}$) für eine positive definierte Vorspannung der Elektroden oder mit der regulierten Spannung ($V_{REG}$) für eine negative definierte Vorspannung der Elektroden vorzuspannen, wobei die erste Messspannung anhand des ersten Binärworts, das auf das digitale Messsignal eines vorhergehenden Zyklus bezogen ist, oder eines anfänglichen Referenz-Binärworts, das von der Logikeinheit (5) geliefert wird, und entweder als Funktion einer Referenzspannung (Vref), die in dem Digital/Analog-Umsetzer (7) für eine positive Vorspannung erzeugt wird, oder als Funktion einer entgegengesetzten Referenzspannung, die in dem Digital/Analog-Umsetzer (7) für eine negative Vorspannung erzeugt wird, definiert ist, wobei die entgegengesetzte Referenzspannung der Differenz zwischen der regulierten Spannung ($V_{REG}$) und der Referenzspannung (Vref), die durch einen Wert definiert ist, der größer als die Hälfte der regulierten Spannung ($V_{REG}$) ist, entspricht,
b) in einer zweiten Phase (P2) die feste Elektrode des zweiten Kondensators (C2) über die Kommutationseinheit (3) mit einer zweiten Messspannung ($V_{DAC}$), die von dem Digital/Analog-Umsetzer (7) geliefert wird, vorzuspannen und die feste Elektrode des ersten Kondensators (C1) mit der Niederspannung ($V_{SS}$) oder der regulierten Spannung ($V_{REG}$) vorzuspannen, wobei die zweite Messspannung anhand des zweiten Binärworts, das auf das digitale Messsignal bezogen ist, oder des anfänglichen Referenz-Binärworts, das von der Logikeinheit (5) geliefert wird, und entweder als Funktion der Referenzspannung (Vref), falls in der ersten Phase (P1) die positive Vorspannung gewählt wird, oder als Funktion der entgegengesetzten Referenzspannung, falls in der ersten Phase (P1) die negative Vorspannung gewählt wird, definiert ist, wobei das zweite Binärwort in der Logikeinheit (5) als Kehrwert des ersten Binärworts in Bezug auf das Referenz-Binärwort definiert ist, und
c) das digitale Messsignal als Funktion der Erhöhung oder der Erniedrigung der Menge der in die bewegliche Elektrode (CM) injizierten Ladungen anhand der Spannungsänderung an der festen Elektrode des ersten Kondensators (C1) und der Spannungsänderung der festen Elektrode des zweiten Kondensators (C2) beim Übergang von der ersten Phase (P1) zu der zweiten Phase (P2) mit einer in der Logikeinheit (5) bestimmten Schrittweite zu erhöhen oder zu erniedrigen,

wobei das Verfahren **dadurch gekennzeichnet ist, dass** jeder Messzyklus eine erste Reihe von Messphasen mit einer ersten Phase (P1) und einer zweiten Phase (P2) gemäß den Schritten a) und b) mit einer positiven oder negativen Vorspannung der festen Elektroden der Kondensatoren (C1, C2) für die Lieferung eines ersten digitalen Messsignals in der Logikeinheit (5) und eine zweite Reihe von Messphasen mit einer ersten Phase (P1) und einer zweiten Phase (P2) gemäß den Schritten a) und b) mit einer Vorspannung, die zu jener der festen Elektroden der ersten Reihe von Messphasen entgegengesetzt ist, für die Lieferung eines zweiten digitalen Messsignals in der Logikeinheit (5) umfasst.

2. Messverfahren nach Anspruch 1, wobei die Logikeinheit (5) ein erstes Register, um das erste digitale Messsignal zu speichern, und ein zweites Register, um das zweite digitale Messsignal zu speichern, umfasst, **dadurch gekennzeichnet, dass** jede Messung des physikalischen Parameters anhand eines letzten digitalen Werts jedes digitalen Signals, das in dem ersten Register und in dem zweiten Register einer vorhergehenden Messung gespeichert worden ist, beginnt.

3. Messverfahren nach einem der Ansprüche 1 und 2, **dadurch gekennzeichnet, dass** in jeder ersten Phase (P1) von Messzyklen die bewegliche Elektrode (CM) des ersten und des zweiten Kondensators (C1, C2) mit einer Spannung vorgespannt wird, die zwischen der Niederspannung ($V_{SS}$) und der regulierten Spannung ($V_{REG}$) liegt.

4. Messverfahren nach Anspruch 3, **dadurch gekennzeichnet, dass** die bewegliche Elektrode (CM) des ersten und des zweiten Kondensators (C1, C2) in jeder ersten Phase (P1) auf eine Spannung vorgespannt wird, die gleich der Hälfte der regulierten Spannung ($V_{REG}$) ist.

5. Messverfahren nach Anspruch 1, wobei die Referenzspannung (Vref) oder die entgegengesetzte Referenzspannung in dem Digital/Analog-Umsetzer (7) mittels eines Widerstandsteilers (27) erzeugt werden, der in einer ersten Richtung mit der Versorgungsspannungsquelle zwischen der regulierten Spannung ($V_{REG}$) und der Niederspannung ($V_{SS}$)

verbunden ist, um die positive Vorspannung mit der Referenzspannung (Vref) zu definieren, und in einer zu der ersten Richtung entgegengesetzten zweiten Richtung mit der Versorgungsspannungsquelle verbunden ist, um die negative Vorspannung mit der entgegengesetzten Referenzspannung zu definieren, wobei jeder Knoten von Widerständen des Widerstandteilers mit einem Multiplexer (17) verbunden ist, der durch das erste binäre Wort oder das zweite binäre Wort in der Weise gesteuert wird, dass über die Kommutationseinheit (3) in der ersten Phase (P1) die erste Messspannung an die feste Elektrode des ersten Kondensators (C1) und in der zweiten Phase (P2) die zweite Messspannung an die feste Elektrode des zweiten Kondensators (C2) geliefert werden.

6. Messverfahren nach Anspruch 5, wobei die Referenzspannung (Vref) in dem Digital/Analog-Umsetzer (7) auf einen Wert gesetzt wird, der größer oder gleich dem 1,5-Fachen der Hälfte der regulierten Spannung ($V_{REG}$) ist, und wobei das Referenz-Binärwort einem digitalen Wert in der Logikeinheit (5) der Mitte der Messspanne entspricht, um am Beginn von Messzyklen an den Multiplexer (17) des Digital/Analog-Umsetzers (7) geliefert zu werden, um für eine positive Vorspannung der festen Elektroden eine Messspannung ($V_{DAC}$) zu liefern, die gleich der Referenzspannung (Vref) ist, und um für eine negative Vorspannung der festen Elektroden eine entgegengesetzte Referenzspannung zu liefern.

7. Elektronische Schnittstellenschaltung (1) für einen kapazitiven Sensor, der ein Paar Kondensatoren (C1, C2) enthält, die differentiell geschaltet sind, wobei die elektronische Schaltung dafür ausgelegt ist, alle Schritte des Messverfahrens nach Anspruch 5 auszuführen,

   wobei die elektronische Schaltung einen Ladungsübertragungsverstärker (4), um mit der gemeinsamen Elektrode (CM) der Kondensatoren verbunden zu werden, eine Logikeinheit (5), die mit dem Ausgang des Verstärkers für eine digitale Verarbeitung der Information, die von dem Verstärker geliefert wird, und für die Lieferung wenigstens eines digitalen Messsignals verbunden ist, einen Digital/Analog-Umsetzer (7), um eine Messspannung ($V_{DAC}$) zu liefern, die anhand einer Umsetzung wenigstens eines ersten Binärwortes oder eines zweiten Binärwortes (DACbus), die auf das digitale Messsignal bezogen sind, zu liefern, und eine Kommutationseinheit (3), die abwechselnd an jede feste Elektrode der zwei Kondensatoren die Messspannung ($V_{DAC}$) und entweder eine regulierte Spannung ($V_{REG}$) oder eine Niederspannung ($V_{SS}$) einer Versorgungs-spannungsquelle liefern kann, umfasst, **dadurch gekennzeichnet, dass** der Digital/Analog-Umsetzer (7) einen Widerstandteiler (27) für die Erzeugung einer Referenzspannung (Vref) für eine positive Vorspannung der festen Elektroden der Kondensatoren oder einer entgegengesetzten Referenzspannung für eine negative Vorspannung der festen Elektroden umfasst, wobei jeder Knoten der Widerstände des Widerstandteilers (27) mit einem Multiplexer (17) verbunden ist, der durch das erste binäre Wort oder das zweite binäre Wort gesteuert werden kann, um dem Digital/Analog-Umsetzer (7) zu ermöglichen, eine erste Messspannung ($V_{DAC}$) anhand des ersten Binärwortes und entweder der Referenzspannung (Vref) oder der entgegen-gesetzten Referenzspannung und eine zweite Messspannung anhand des zweiten Binärwortes und entweder der Referenzspannung (Vref) oder der entgegen-gesetzten Referenzspannung zu liefern.

8. Elektronische Schaltung (1) nach Anspruch 7, **dadurch gekennzeichnet, dass** der Widerstandteiler (27) des Digital/Analog-Umsetzers (7) mehr als 1000 Widerstände, die paarweise den gleichen Widerstandswert haben, beispielsweise 1536 einheitliche Widerstände, umfasst.

9. Elektronische Schaltung (1) nach Anspruch 7, **dadurch gekennzeichnet, dass** die Logikeinheit (5) ein erstes Register zum Speichern eines ersten digitalen Messsignals für eine positive Vorspannung der festen Elektroden der Kondensatoren (C1, C2) und ein zweites Register zum Speichern eines zweiten digitalen Messsignals für eine negative Vorspannung der festen Elektroden der Kondensatoren (C1, C2) umfasst und dass die Logikeinheit (5) vorgesehen ist, das erste digitale Messsignal, das in dem ersten Register gespeichert ist, und das zweite digitale Messsignal, das in dem zweiten Register gespeichert ist, zu kombinieren oder zu addieren, um ein digitales Ausgangssignal ($OUT_{DX}$) zu liefern.

10. Elektronische Schaltung (1) nach Anspruch 7, **dadurch gekennzeichnet, dass** sie einen ersten Versorgungsmultiplexer (6) und einen zweiten Versorgungsmultiplexer (8) umfasst, wobei der erste und der zweite Versorgungsmultiplexer (6, 8) vorgesehen sind, um am Eingang die regulierte Spannung ($V_{REG}$) und die Niederspannung ($V_{SS}$) zu empfangen, dass der Ausgang des ersten Versorgungsmultiplexers (6) mit einem ersten Anschluss des Widerstandteilers (27) verbunden ist, dass der Ausgang des zweiten Versorgungsmultiplexers (8) mit einem zweiten Anschluss des Widerstandteilers (27) verbunden ist und dass der erste und der zweite Multiplexer (6, 8) durch ein Vorspannungssteuersignal (pol) gesteuert werden, derart, dass die regulierte Spannung ($V_{REG}$) am ersten Anschluss des Widerstandteilers (27) geliefert wird und die Niederspannung ($V_{SS}$) am zweiten Anschluss des Widerstandteilers (27) geliefert wird, um die Referenzspannung (Vref) einer positiven Vorspannung zu erzeugen, und dass die Niederspannung ($V_{SS}$) am ersten Anschluss des Widerstandteilers (27) geliefert wird und die regulierte Spannung

($V_{REG}$) am zweiten Anschluss des Widerstandsteilers (27) geliefert wird, um die entgegen-gesetzte Referenzspannung einer negativen Vorspannung zu erzeugen.

**Claims**

1. Method of measuring a physical parameter by means of an electronic interface circuit (1) connected to a capacitive sensor (2), which includes at least first and second differential-connected capacitors (C1, C2), whose common electrode (CM) is capable of moving relative to each fixed electrode of the two capacitors to modify the capacitive value of each capacitor when the physical parameter is measured, said electronic circuit including a charge transfer amplifier (4), which is connected to the common electrode (CM), a logic unit (5) connected to the amplifier output for digital processing of the data supplied by the amplifier and for supplying at least one digital measuring signal, a digital-analogue converter (7) for supplying a measuring voltage, which is defined on the basis of conversion of at least a first binary word or a second binary word (DACbus) relating to the digital measuring signal, a switching unit (3) for alternately supplying each fixed electrode of the two capacitors with the measuring voltage ($V_{DAC}$), and a regulated voltage ($V_{REG}$) or a low voltage ($V_{SS}$) from a supply voltage source, the method including, in each successive measuring cycle, steps consisting in:

   a) in a first phase (P1), biasing the fixed electrode of the first capacitor (C1) via the switching unit (3) with a first measuring voltage ($V_{DAC}$) supplied by the digital-analogue converter (7), and the fixed electrode of the second capacitor (C2) with the low voltage ($V_{SS}$) for defined positive biasing of the electrodes, or the regulated voltage ($V_{REG}$) for defined negative biasing of the electrodes, the first measuring voltage being defined on the basis of the first binary word relating to the digital measuring signal from a preceding cycle or an initial binary reference word supplied by the logic unit (5), and according to a reference voltage (Vref) generated in the digital-analogue converter (7) for positive biasing, or according to an inverted reference voltage generated in the digital-analogue converter (7) for negative biasing, the inverted reference voltage corresponding to the difference between the regulated voltage ($V_{REG}$) and the reference voltage (Vref), which is set at a value higher than half of the regulated voltage ($V_{REG}$),
   b) in a second phase (P2), biasing the fixed electrode of the second capacitor (C2) via the switching unit (3) with a second measuring voltage ($V_{DAC}$) supplied by the digital-analogue converter (7) and the fixed electrode of the first capacitor (C1) with the low voltage ($V_{SS}$) or the regulated voltage ($V_{REG}$), the second measuring voltage being defined on the basis of the second binary word relating to the digital measuring signal or the initial reference binary signal supplied by the logic unit (5), and according to the reference voltage (Vref), if positive biasing is selected in the first phase (P1), or according to the inverted reference voltage, if negative biasing is selected in the first phase (P1), the second binary word being defined in the logic unit (5) as the reverse of the first binary word relative to the reference binary word, and
   c) incrementing or decrementing by a determined step in the logic unit (5), the digital measuring signal according to the increase or decrease in charge injection quantity across the moving electrode (CM) on the basis of the voltage variation across the fixed electrode of the first capacitor (C1) and the voltage variation across the fixed electrode of the second capacitor (C2) at the change from the first phase (P1) to the second phase (P2),

   the method being **characterized in that** each measuring cycle includes a first series of measuring phases with a first phase (P1) and a second phase (P2) according to steps a) and b) with positive or negative biasing of the fixed electrodes of the capacitors (C1, C2) for the supply of a first digital measuring signal in the logic unit (5), and a second series of measuring phases with a first phase (P1) and a second phase (P2) according to steps a) and b) with inverted biasing of the fixed electrodes of the first series of measuring phases for the supply of a second digital measuring signal in the logic unit (5).

2. Measuring method according to claim 1, wherein the logic unit (5) includes a first register for storing the first digital measuring signal, and a second register for storing the second digital measuring signal, **characterized in that** each physical parameter measurement starts on the basis of a final digital value for each digital signal stored in the first register and the second register from a preceding measurement.

3. Measuring method according to any one of claims 1 and 2, **characterized in that**, in each first phase (P1) of the measuring cycles, the moving electrode (CM) of the first and second capacitors (C1, C2) is biased at a voltage comprised between the low voltage ($V_{SS}$) and the regulated voltage ($V_{REG}$).

4. Measuring method according to claim 3, **characterized in that** the moving electrode (CM) of the first and second capacitors (C1, C2) is biased in each first phase (P1) at a voltage equal to half of the regulated voltage ($V_{REG}$).

5. Measuring method according to claim 1, wherein the reference voltage (Vref) or the inverted reference voltage are generated in the digital-analogue converter (7) by means of a resistive divider (27) connected in a first direction to the supply voltage source between the regulated voltage ($V_{REG}$) and the low voltage ($V_{SS}$) to define positive biasing with the reference voltage (Vref) and connected in a second opposite direction to the first direction to the voltage supply source to define negative biasing with the inverted reference voltage, each node of the resistors of the resistive divider being connected to a multiplexer (17) controlled by the first binary word or the second binary word so as to supply, via the switching unit (3), the first measuring voltage to the fixed electrode of the first capacitor (C1) in the first phase (P1) and the second measuring voltage to the fixed electrode of the second capacitor (C2) in the second phase (P2).

6. Measuring method according to claim 5, wherein the reference voltage (Vref) is established in the digital-analogue converter (7) at a value higher than or equal to 1.5 times half the regulated voltage ($V_{REG}$), and wherein the reference binary word corresponds to a digital value in the logic unit (5) in the middle of the measuring range to be supplied at the start of the measuring cycles to the multiplexer (17) of the digital-analogue converter (7), so as to supply a measuring voltage ($V_{DAC}$) equal to the reference voltage (Vref) for positive biasing of the fixed electrodes and an inverted reference voltage for negative biasing of the fixed electrodes.

7. Electronic interface circuit for a capacitive sensor, which includes a pair of differential-connected capacitors (C1, C2), the electronic circuit being adapted for implementing all the steps of the measuring method according to claim 5, the electronic circuit including a charge transfer amplifier (4) to be connected to the common electrode (CM) of the capacitors, a logic unit (5) connected to the amplifier output for digital processing of data supplied by the amplifier and for supplying at least one digital measuring signal, a digital-analogue converter (7) for supplying a measuring voltage ($V_{DAC}$), which is defined on the basis of conversion of at least a first binary word or a second binary word (DACbus) relating to the digital measuring signal, a switching unit (3) capable of alternately supplying each fixed electrode of the two capacitors with the measuring voltage ($V_{DAC}$), and a regulated voltage ($V_{REG}$) or a low voltage ($V_{SS}$) from a supply voltage source,
**characterized in that** the digital-analogue converter (7) includes a resistive divider (27) for generating a reference voltage (Vref) for positive biasing of the fixed electrodes of the capacitors, or an inverted reference voltage for negative biasing of the fixed electrodes, each node of the resistors of the resistive divider (27) being connected to a multiplexer (17), which may be controlled by the first binary word or the second binary word to allow the digital-analogue converter (7) to supply a first measuring voltage ($V_{DAC}$) on the basis of the first binary word and the reference voltage (Vref) or the inverted reference voltage, and a second measuring voltage on the basis of the second binary word and the reference voltage (Vref) or the inverted reference voltage.

8. Electronic circuit according to claim 7, **characterized in that** the resistive divider (27) of the digital-analogue converter (7) includes more than 1000 matched resistors having the same resistive value, for example 1536 individual resistors.

9. Electronic circuit according to claim 7, **characterized in that** the logic unit (5) includes a first register for storing a first digital measuring signal for positive biasing of the fixed electrodes of the capacitors (C1, C2), and a second register for storing a second digital measuring signal for negative biasing of the fixed electrodes of the capacitors (C1, C2), and **in that** the logic unit (5) is arranged to combine or add the first digital measuring signal stored in the first register and the second digital measuring signal stored in the second register to supply a digital output signal ($OUT_{DX}$).

10. Electronic circuit according to claim 7, **characterized in that** it includes a first supply multiplexer (6) and a second supply multiplexer (8), the first and second supply multiplexers (6, 8) being arranged to receive at input the regulated voltage ($V_{REG}$) and the low voltage ($V_{SS}$), **in that** the output of the first supply multiplexer (6) is connected to a first terminal of the resistive divider (27), **in that** the output of the second supply multiplexer (8) is connected to a second terminal of the resistive divider (27), and **in that** the first and second multiplexers (6, 8) are controlled by a polarity control signal (pol) in order to supply the regulated voltage ($V_{REG}$) to the first terminal of the resistive divider (27) and the low voltage ($V_{SS}$) to the second terminal of the resistive divider (27), to generate the reference voltage (Vref) for positive biasing, and to supply the low voltage ($V_{SS}$) to the first terminal of the resistive divider (27) and the regulated voltage ($V_{REG}$) to the second terminal of the resistive divider (27), to generate the inverted reference voltage for negative biasing.

Fig. 1

EP 2 662 667 B1

Fig. 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1835263 B1
- WO 2004113930 A1
- WO 2008107737 A1
- EP 2343507 A1
- EP 0525830 A1

**Littérature non-brevet citée dans la description**

- **MM. H. LEUTHOLD ; F. RUDOLPH.** *Sensors and actuators,* 1990, vol. A21-A23, 278-281
- A 1 mV MOS Comparator. *IEEE J. Solid-State Circuits,* Juin 1978, vol. SC-13, 294-297